# EUROPEAN PATENT APPLICATION

(11) **EP 4 685 796 A1**
(43) Date of publication of application: **28.01.2026**
(21) Application number: 22315120.0
(22) Date of filing: 17.06.2022
(51) Int. Cl.: G11C 11/16, H10N 50/80

(54) **MAGNETIC MEMORY CELL AND SELF-ALIGNED MANUFACTURING METHOD THEREOF**

(71) Applicant: Antaios, 38240 Meylan (FR)
(72) Inventor: Drouard, Marc, 38240 MEYLAN (FR); Levi, Amitay, CUPERTINO, 95014-1818 (US); Kumar, Raj, SAN JOSE, 95131 (US); Martin, Sylvain, 38240 MEYLAN (FR)

(57) **Abstract**

A SOT-MRAM (400) comprising a substrate dielectric layer (SubOx); a first and a second electrically conductive lines (El_{A}, El_{B}) formed in a same plane over the substrate dielectric layer (SubOx); a first dielectric layer (Diel1) over the substrate dielectric layer (SubOx) and interposed between the first and the second electrically conductive lines (El_{A}, El_{B}); a magnetic tunnel junction (MTJ) formed over the first dielectric layer (Diel1) and comprising a SOT layer (SOT) at a lowermost position of the magnetic tunnel junction (MTJ), the SOT layer (SOT) connecting the first electrically conductive layer (El_{A}) to the second electrically conductive layer (El_{B}), wherein top surfaces of the first and the second electrically conductive lines (El_{A}, El_{B}) present depressions at least partially filled with a second dielectric layer (Diel2).

## Description

### FIELD OF THE INVENTION

The technical domain of the invention is that of Magnetoresistive Random Access Memory (MRAM) cells, that each comprises a Magnetic Tunnel Junction (MTJ) whose magnetic state defines a bit of information, and more specifically MRAM cells making use of a spin orbit interaction (SOT) layer.

### BACKGROUND OF THE INVENTION

An MTJ comprises a stack of two ferromagnetic layers separated by an electrically insulating tunnel layer that is thin enough to allow electrons to pass from one of the ferromagnetic layers to the second one by quantum tunneling.

The resistance of the MTJ to electrical current passage is governed by quantum mechanical physics and more specifically by Tunnel Magnetoresistance (TMR).

One of the two ferromagnetic layer has a pinned (or fixed) magnetization while the other one has a magnetization that can be modified, and they are therefore often referred to as the pinned ferromagnetic layer (or fixed ferromagnetic layer, or also reference ferromagnetic layer) and the free ferromagnetic layer, respectively.

In an actual device, an MTJ comprises other layers in addition to those cited so far, used to improve control over the states of the MTJ and/or inject currents therein and/or that are necessary for its manufacturing process.

A prominent example of such additional layer would be an antiferromagnetic synthetic structure pinning the magnetization of the pinned layer.

An MTJ exhibits two states: a low-resistance state in which magnetizations of the two ferromagnetic layers are in a parallel state, i.e. magnetizations of both ferromagnetic layers are oriented towards a same direction, and a high-resistance state in which magnetizations of the two ferromagnetic layers are in an antiparallel state, i.e. magnetizations of the two ferromagnetic layers are oriented towards two opposite directions.

Each memory cell of an MRAM comprises an MTJ in which these two states and their corresponding electrical resistance values are associated to bit values, "0" or "1", that are read by circulating an electrical current through the MTJ to determine its electrical resistance value.

The pinned ferromagnetic layer is used as a reference ferromagnetic layer and the free ferromagnetic layer can be written (i.e. its magnetization orientation can be controlled) at will by application of a current or a magnetic field.

Regarding the writing mechanism, one may cite three types of MRAM: Field switching MRAM, Spin Transfer Torque MRAM (STT-MRAM) and Spin Orbit Torque MRAM (SOT-MRAM), that differ in their mechanisms for writing the free ferromagnetic layer.

In a SOT-MRAM cell, modification, or writing, of the state of the magnetic tunnel junction is carried out by circulating an electrical current in a spin-orbit interaction active layer, or SOT layer, that is in direct contact with the free ferromagnetic layer Ferro_{f} of the MTJ.

The SOT layer has for function to facilitate switching of the magnetization orientation of the free ferromagnetic layer upon circulation of the writing current Iw in the SOT layer.

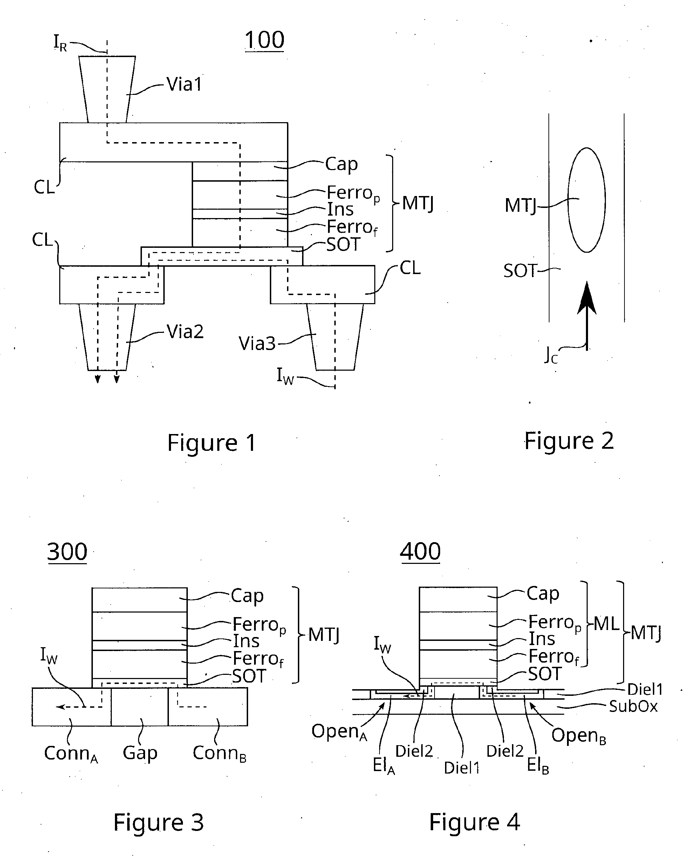

A SOT-MRAM cell possesses 3 terminals: one is used commonly for circulating both of the writing current Iw and the reading current I_{R}, and a second and a third terminals are dedicated each to one of the writing current I_{W} and the reading current I_{R}, these three terminals often corresponding to three respective vias Via1, Via2 and Via3 and corresponding electrically conductive lines CL for electrical connections with the circuitry of the memory, as in the SOT-MRAM 100 illustrated by Fig. 1.

Fig. 1 also illustrates a tunnel insulating layer Ins interposed between Ferro_{f} and Ferroₚ, and a capping layer Cap situated on top of the MTJ, capping layer that can comprise an electrically conductive layer or an antiferromagnetic layer exchange coupling ferromagnetic layer Ferroₚ to pin the magnetization thereof; alternatively, the capping layer Cap can comprise a synthetic ferromagnet structure including a metallic non-magnetic spacer layer and a ferromagnetic layer or a plurality of such layers in alternance; further, the cap layer may comprise any additional layer required by the practitioner to attain any specific functions and/or specifications.

Commonly, the structures above are made using conventional microfabrication processes involving alignment operations that cannot be carried out with an absolute precision, so that the patterns that are employed to define the different elements of the structure to be made present some dimensional margins.

As an example of a mitigation measure to make up for such technical limitations, the width of the SOT layer is conventionally larger than the lateral dimensions of the rest of the MTJ stack of, as illustrated in Fig. 2, which limits the potential miniaturization of such cell.

This implies that to maintain a given current density Jc, the total current needs to be higher, increasing transistor size in the circuit controlling the MRAM memory cell and using more power during write operation.

Further, slight differences in alignment in processes requiring alignment operations result in variations between batches of MRAM memories.

To make up for these shortcomings, Patent Application publication EP3882995A1 teaches a SOT-MRAM 300 having the structure illustrated by Fig. 3.

Here, connections to the SOT layer are made by forming a gap Gap between two connection layers Conn_{A} and Conn_{B} and forming the stack of a magnetic tunnel junction MTJ so as to bridge the two connection layers over the gap.

However, the manufacturing process of such a structure involves an etching process through the whole stack of the MTJ, down to the connection layers Conn_{A} and Conn_{B} used at this time as etch stop layers.

During this process, metal particles can be sputtered and redeposited onto the sidewall of the MTJ, shorting the tunnel insulating layer Ins and degrading the performance of the memory cell.

### OBJECT OF THE INVENTION

The present invention aims at providing SOT-MRAM cells that do not suffer from the drawback explained above, and a manufacturing method thereof.

### SUMMARY OF THE INVENTION

To this effect, a first aspect of the invention relates to a SOT-MRAM cell comprising a substrate dielectric layer ; a first and a second electrically conductive lines formed in a same plane over the substrate dielectric layer ; a first dielectric layer (Diel1) over the substrate dielectric layer and interposed between the first and the second electrically conductive lines ; a magnetic tunnel junction formed over the first dielectric layer and comprising a SOT layer at a lowermost position of the magnetic tunnel junction, the SOT layer connecting the first electrically conductive layer to the second electrically conductive layer, wherein top surfaces of the first and the second electrically conductive lines present depressions at least partially filled with a second dielectric layer.

Such a SOT-MRAM benefits from the advantages of a structure resulting from a self-aligned process while keeping sidewalls of the magnetic tunnel junction substantially free of pollution by metal particles.

According to further non limitative features of the first aspect of the invention, either taken alone or in any technically feasible combination:
- a sidewall of the SOT layer can be laterally aligned with a sidewall of other layers forming the magnetic tunnel junction;
- the first and the second electrically conductive lines can be formed in respective openings of the first dielectric layer;
- the magnetic memory cell can further comprise a ferromagnetic layer over the first and the second electrically conductive lines and surrounding the magnetic tunnel junction;
- the magnetic memory cell can further comprise an electrically insulating encapsulating layer interposed between the ferromagnetic layer and each of the first and the second electrically conductive lines and the magnetic tunnel junction;
- the magnetic memory cell can further comprise a dielectric planarization layer over the first and the second electrically conductive lines and surrounding the magnetic tunnel junction;
- the magnetic memory cell can further comprise an electrically insulating encapsulating layer interposed between the dielectric planarization layer and each of the first and the second electrically conductive lines and the magnetic tunnel junction; and
- the magnetic memory cell can further comprise a first and a second vias embedded in the substrate dielectric layer, the first and the second vias being respectively in direct contact with the first and the second electrically conductive lines.

A second aspect of the invention relates to a manufacturing process of a SOT-MRAM cell, comprising the steps of: providing a substrate covered with a substrate dielectric layer ; forming a first dielectric layer over the substrate, the first dielectric layer comprising a first and a second openings ; forming a first metal layer and a second dielectric layer over the substrate and the first dielectric layer; grinding down the first metal layer and the first dielectric layer by a chemical mechanical polishing process, thereby forming a first and a second electrically conductive lines having top surfaces presenting.depressions at least partially filled with the second dielectric layer ; patterning a magnetic tunnel junction on the first dielectric layer, the magnetic tunnel junction comprising a SOT layer as a lowermost part thereof, in direct contact with the dielectric layer and each of the first and the second electrically conductive lines.

Such a manufacturing process limits the risks of metal pollution of a sidewall of the magnetic tunnel layer of a SOT-MRAM (due to metal sputter back on the sidewall of the magnetic tunnel junction) by covering most of the metal that could be pulverized with a dielectric layer.

According to further non limitative features of the second aspect of the invention, either taken alone or in any technically feasible combination:
- the step of forming the magnetic tunnel junction can comprise sub-steps of (i) forming the magnetic tunnel junction by depositing successively and in this order the SOT layer, a free ferromagnetic layer, a tunnel insulating layer Ins and a pinned ferromagnetic layer; and (ii) patterning the magnetic tunnel junction by an anisotropic etching of the pinned ferromagnetic layer, the tunnel insulating layer, the free ferromagnetic layer and the SOT layer by using a same mask ;
- the manufacturing process of a SOT-MRAM cell can further comprise a step comprising(i) forming successively and in this order an electrically insulating encapsulating layer and a second metal layer over the patterned magnetic tunnel junction and the first and the second electrically conductive lines ; and (ii) polishing the second metal layer and the electrically insulating encapsulating layer by a chemical mechanical polishing process down to an uppermost surface of the magnetic tunnel junction;
- the manufacturing process of a SOT-MRAM cell can further comprise a step comprising (i) forming successively and in this order an electrically insulating encapsulating layer and a dielectric planarization layer over the patterned magnetic tunnel junction and the first and the second electrically conductive lines ; and (ii) polishing the dielectric planarization layer and the electrically insulating encapsulating layer by a chemical mechanical polishing process down to an uppermost surface of the magnetic tunnel junction;
- a top surface of the provided substrate can be covered with a substrate dielectric layer in which a first and a second vias are embedded, and
wherein the first and the second electrically conductive lines are formed in direct contact with the first via and the second via, respectively.

### FIGURES

Many other features and advantages of the present invention will become apparent from reading the following detailed description, when considered in conjunction with the accompanying drawings, in which:
[Fig. 1] Figure 1 illustrates the structure and operations of a SOT-MRAM cell ;
[Fig. 2] Figure 2 illustrates the operation of a conventional SOT-MRAM ;
[Fig. 3] Figure 3 illustrates the structure and the writing operation of a known SOT-MRAM;
[Fig. 4] Figure 4 illustrates the structure and the writing operation of SOT-MRAM according to the present invention;
[Fig. 5-1] Figure 5-1, [Fig. 5-2] Figure 5-2, [Fig. 5-3] Figure 5-3, [Fig. 5-4] Figure 5-4, and [Fig. 5-5] Figure 5-5 illustrate a manufacturing process and the structure of a SOT-MRAM according to the invention.

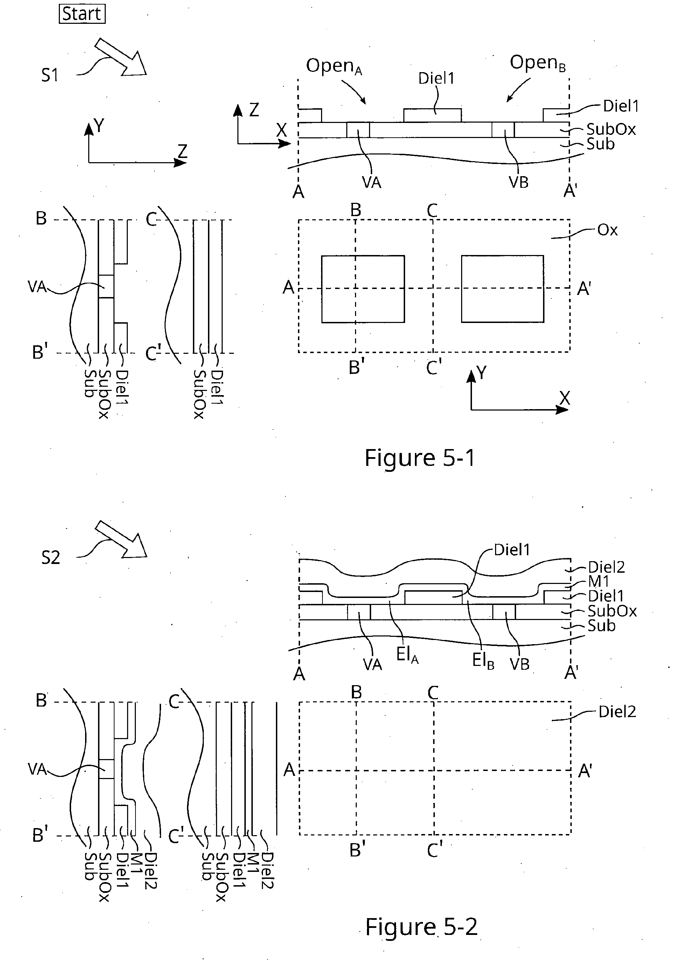

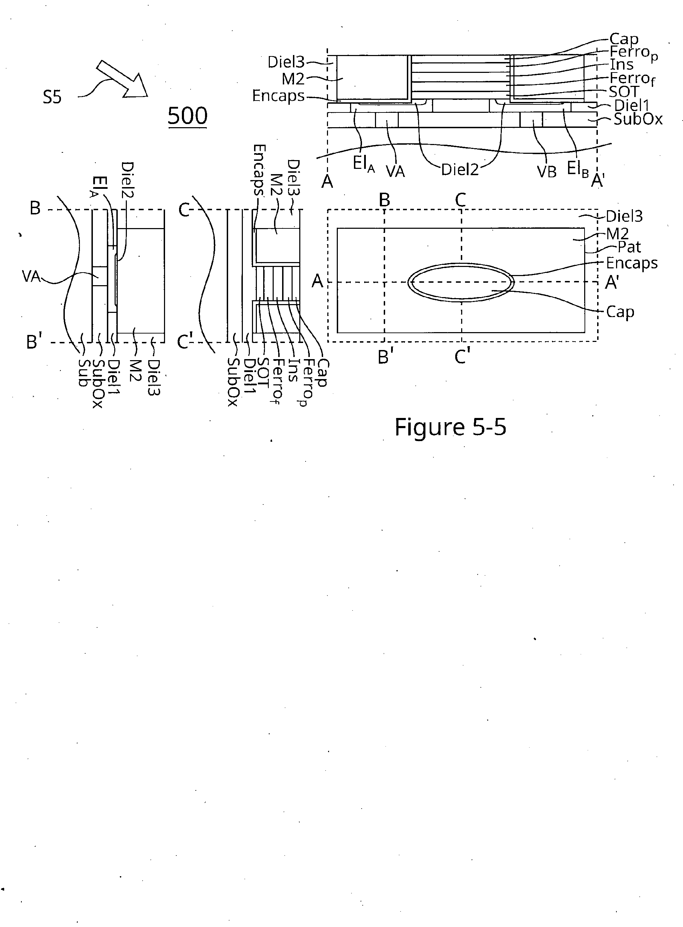

Figs. 5-1 to 5-5 each comprise a plan view parallel to a plane defined by axes X and Y, a cross-section view taken along a segment AA' of the plan and parallel to a plane defined by axes X and Z, and cross-section views taken along segments BB' and CC' of the plan view and parallel to a plane defined by axes Y and Z.

Axes X, Y and Z define a three dimensional orthogonal reference frame and, for explanation purposes, the plan view is considered as horizontal and axis Z is considered as defining the vertical direction.

The figures are schematic representations that, for the sake of clarity, are not drawn to scale and, in particular, thicknesses of layers along axis Z are not to scale compared to lateral dimensions along axis X and axis Y.

### DETAILED DESCRIPTION OF SPECIFIC EMBODIMENTS OF THE INVENTION

A SOT-MRAM cell 400 according to the invention has its basic structure illustrated by Fig. 4.

The SOT-MRAM cell 400 is formed on a substrate dielectric layer SubOx over which is formed a first dielectric layer Diel1.

The first dielectric layer Diel1 comprises two through openings OpenA and OpenB in which are embedded two electrically conductive lines El_{A} and El_{B}, respectively, so that these two lines are formed in a same horizontal plane and are spaced apart by a portion of the first dielectric layer Diel1.

Top surfaces of the first and the second electrically conductive lines El_{A} and El_{B} present depressions at least partially filled with a second dielectric layer Diel2 used to protect these conductive lines from sputtering and prevent redeposition of sputtered material onto surrounding structures, and notably onto the sidewall of the MTJ.

Over the portion of the dielectric layer Diel1 spacing apart the two electrically conductive lines El_{A} and El_{B} is formed a magnetic tunnel junction MTJ made of, from top to bottom, a cap layer Cap, a pinned ferromagnetic layer Ferroₚ, a tunnel insulating layer Ins, a free ferromagnetic layer Ferro_{f} and a SOT layer SOT.

Notably, all the layers of the magnetic tunnel junction are patterned using a same mask.

As a consequence, a sidewall of the SOT layer is laterally aligned, or flushed, with a sidewall of the other layers forming the magnetic tunnel junction, in contrast to most conventional SOT-MRAM cells, illustrated by Fig. 1.

The magnetic tunnel junction is situated and dimensioned in such a way that lower surfaces of two opposite edges of the SOT layer are in direct contact with a respective one of the two electrically conductive lines El_{A} and El_{B}.

Further, the two electrically conductive lines are mostly covered by a dielectric layer Diel2, drastically reducing the redeposition of the material constituting these lines onto sidewalls of the magnetic tunnelling junction during manufacture of the SOT-MRAM cell.

An example embodiment of the invention is constituted by the manufacturing process and corresponding structures described below and illustrated by figures 5-1 to 5-5.

Additional features and advantages will be explained at relevant sections describing the manufacturing process.

In this description, nature and thicknesses of some layers deposited through the disclosed process taken as example are shown in brackets, but are merely indicative and a practitioner will understand that they can be can be modified according to the specific structure and characteristics of a given application.

Further, except otherwise specified, any process conventionally employed in the semiconductor industry may be used to perform the disclosed steps of manufacturing, as will be understood by the skilled technician in the field.

The first step of the manufacturing process consists in providing (Start) a semiconductor substrate Sub equipped with a circuitry intended to control an MRAM.

The substrate Sub is provided covered with substrate dielectric layer SubOx in which electrical connections are embedded, in the present examples, two vias VA and VB are provided, for example obtained by a conventional Damascene process and materials.

It is to be noted that this geometry is favorable to scalability because connection to the SOT layer does not require additional vias coming over the SOT layer or connecting the considered MRAM cell to the circuitry provided on the substrate and intended for its control.

After providing the substrate, a step S1 is carried out, that comprises a first sub-step that consists in depositing, onto layer SubOx and the vias embedded therein, a first dielectric layer Diel1 (60 nm, silicon oxide such as a TEOS silicon oxide); and a second sub-step that consists in patterning two through openings OpenA and OpenB in the first dielectric layer Diel1, exposing top surfaces of the vias VA and VB, respectively, which results in the structure illustrated by Fig. 5-1.

Next, a step S2 is carried out, that comprises a fist substep of depositing a conformal first metal layer M1 (tantalum or tungsten, 10 to 20 nm) by means of a deposition process such as chemical vapor deposition leading to a conformal and continuous layer M1 onto inner surfaces of the openings Open_{A} and Open_{B}, and depositing a second dielectric layer Diel2 (60 nm, silicon oxide such as a TEOS silicon oxide) onto the first metal layer M1, resulting in the structure illustrated by Fig. 5-2.

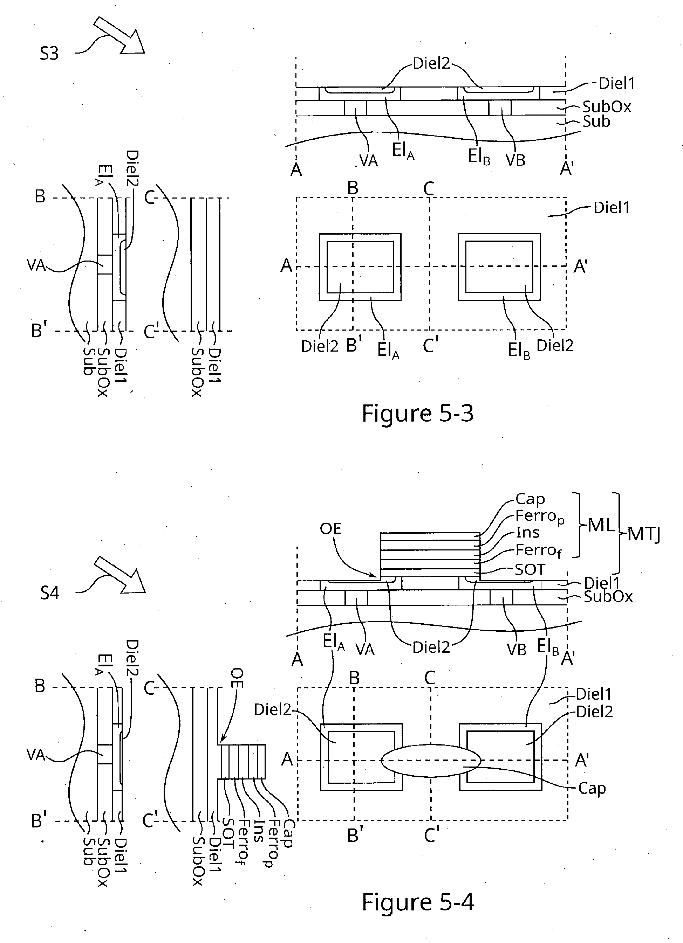

Following the deposition of the layers M1 and Diel2, a chemical mechanical polishing process is carried out at a step S3, grinding down these two layers sufficiently to eliminated the layer M1 from top surfaces of the first dielectric layer Diel1, resulting' in the structure illustrated by Fig. 5-3 with electrically conductive lines El_{A} and El_{B} formed from the first metal layer M1 and respectively in direct contact with the vias VA and VB, resulting in the structure illustrated by Fig. 5-3.

As a consequence of the process described above, top surfaces of the first and the second electrically conductive lines El_{A} and El_{B} present depressions at least partially (totally in the illustrated example) filled with the second dielectric layer Diel2.

Then, at a step S4, a magnetic tunnel junction MTJ is patterned on the first dielectric layer (Diel1), a first substep of S4 comprising the successive depositions onto the structure obtained through steps S1 to step S3, of a SOT layer SOT, a free ferromagnetic layer Ferro_{f}, a tunnel insulating layer Ins, a pinned ferromagnetic layer Ferroₚ and a cap layer Cap, in this order, that stack of each of these layer constituting the magnetic tunnel layer MTJ.

SOT layer SOT can comprises a SOT material, where the SOT material can include an electrically conductive material such as Pt, W, Ir, Ru, Pd, Cu, Au, Bi, Hf, Se, Sb or of an alloy of these elements, or is formed of a stack of a plurality of layers of each of these metals.

Alternatively, SOT layer SOT can be made from an antiferromagnetic material such as alloys with a base of Mn such as IrMn, FeMn, PtMn, or alloys of these compounds such as PtFeMn.

Alternatively, the SOT layer SOT can be made from a ferromagnetic material, such as Fe, Co, Ni or of an alloy of these elements.

Still alternatively, SOT layer SOT can be made from a topological insulator, such as bismuth-based topological insulators or antimony chalcogenide based topological insulators (Bi₂Se₃, Bi₂Te₃, Sb₂Te₃ or Bi₁₋ₓSbₓ, Bi₁.₁Sb_{0.9}Te₂S etc...) , because the SOT layer can be very thin.

SOT layer SOT has a thickness comprised between 0.5 nm and 200 nm, preferably between 0.5 and 10 nm, more preferably between 0.5 nm and 5 nm.

Ferroelectric layers Ferro_{f} and Ferroₚ can comprise a ferromagnetic material including a metal or alloy having a specific perpendicular magnetic anisotropy whereby magnetizations of these layers are oriented substantially vertically (perpendicular to the plane of the ferromagnetic layers, configuration known as out-of-plane or perpendicular magnetic anisotropy PMA).

Such metal or alloy can comprise FePt, FePd, CoPt, or a rare earth/transition metal alloy, in particular GdCo, TdFeCo, or Co, Fe, CoFe, Ni, CoNi, CoFeB, FeB.

Alternatively, the ferromagnetic layers Ferro_{f} and Ferroₚ can comprise a metal or alloy with magnetizations oriented parallel to the plane of the ferromagnetic layers Ferro_{f} and Ferroₚ (in-plane).

Such metal or alloy can comprise Co, Fe, CoFe, Ni, NiFe, CoNi, CoFeB, FeB.

The thickness of the ferromagnetic layers Ferro_{f} and Ferroₚ can be comprised between 0.5 nm and 10 nm and preferably between 1 and 3 nm.

The tunnel insulating layer Inc can include a dielectric material such as MgO or Al₂O₃.

Capping layer Cap can comprise a synthetic ferromagnet structure including a metallic non-magnetic spacer layer and a ferromagnetic layer or a plurality of such layers in alternance; further, the cap layer may comprise any additional layer required by the practitioner to attain any specific functions and/or specifications.

A second sub-step of S4 consist in anisotropically etching each of the layers constituting the magnetic tunnel junction MTJ, selectively through a mask by a conventional photolithography process.

In addition, layers Diel1 and Diel2 and electrically conductive lines El_{A} and El_{B} are also partially submitted to the anisotropic etching process resulting in an overetching OE that can be visualized for example as a step visible in layer Diel2 and adjacent to a sidewall of the magnetic tunnel junction MTJ, as indicated in Fig. 5-4.

A function of layer Diel2 is to cover the conductive lines El_{A} and El_{B} so as to limit pulverization of these conductive lines to prevent redeposition of a conductive material onto the sidewalls of the magnetic tunnel junction MTJ during the second sub-step of S4.

In order to limit redeposition of metal particles originating from lines El_{A} and El_{B}, it is preferable that at least 60% of the surface of these layers are covered by dielectric layer Diel2, more preferably at least 80%, and even more preferably at least 90%.

The magnetic tunnel junction MTJ is patterned so that bottom surfaces of two opposite portions of the SOT layer (the lowermost layer of the magnetic tunnel junction MTJ) are in direct contact with respective ones of top surfaces of the two electrically conductive lines El_{A} and El_{B}.

Said two opposite portions of layer SOT are preferably close to edges of layer SOT, in order to maximize usefulness of any given writing current entering and exiting layer SOT through electrically conductive lines El_{A} and E1_{B}.

In Fig. 5-4, the magnetic junction layer is illustrated as an ellipsis having a major axis parallel to a direction along which the two vias VA and VB are localized, but such a geometry is not intended to limit the scope of the invention, as other geometries could be employed (circle, square, rectangle...).

Next, step S5 comprises a first sub-step of depositing successively and in this order an electrically insulating encapsulating layer Encaps and a second metal layer M2 onto the structure resulting from step S4.

Layer M2 is primarily intended to form magnets used to magnetically bias the free ferromagnetic layer Ferro_{f}, and is preferably thick enough to occupy at least a horizontal level where layer Ferrof is situated so as to have a sidewall facing a sidewall of layer Ferro_{f}.

Layer M2 may comprise any one of Co, Fe, Ni, CoFeB, NiFe, CoFe, CoPt, CoCrPt and their alloys.

Also, layer M2 is preferably a stack of layers, comprising for example a seed layer and a cap layer sandwiching a core ferromagnetic layer, as is well known in the field.

Layer Encaps prevents layer M2 from shorting together electrically conductive lines El_{A} and El_{B}. and to enter in electrical contact with the magnetic tunnel junction vis sidewall thereof, and prevents as well direct exchange coupling between layer M2 and free ferromagnetic layer Ferro_{f}, by comprising a solid phase element having a resistivity above 5×10⁻⁵ Ω.m and a thickness comprised between 0.5 and 50 nm.

Such an element can be chosen among SiN, AlO₂, HFO₂ and Al₂O₃.

A second sub-step of S5 consists in patterning layers Encaps and M2 by conventional lithography technic to limit the extension, in particular, of metal layer M2 to a single SOT-MRAM cell, as indicated inf Fig. 5-5 by pattern Pat corresponding to a perimeter of layer M2.

The second substep may optionally require the formation of a hard mask on layer M2, hard mask that may be removed in the next sub-step.

A third sub-state of S5 consists in, after the patterning of layers Encaps and M2, depositing a third dielectric layer Diel3 for the purpose of planarizing the device being manufactured.

A fourth subs-step of S5 consists in, similarly to step S3, performing a chemical mechanical polishing process so as to grind down layers Diel3, M2 and Encaps (and the optional hard mask if applicable) sufficiently to eliminate these layers from above the magnetic tunnel junction, resulting in a structure having a substantially planarized surface with layer Cap being exposed, as in the SOT-MRAM cell 500 illustrated by Fig. 5-5.

It is to be noted that, in the case where a magnetic bias of the free ferromagnetic layer Ferro_{f} is not necessary, layer M2 can be made from a dielectric material to form a dielectric planarization layer.

Layer M2 (when applicable) and the first to third dielectric layers Diel1, Diel2, and Diel3 can be made of a dielectric material usually employed in the semiconductor field such as silicon dioxide, and more particularly a TEOS-obtained silicon dioxide.

Still, the practitioner in the field is able to determine the materials and thicknesses of the various layers forming the SOT-MRAM cell 500 for specific structures and characteristics of a given target application for the SOT-MRAM.

Afterwards, the magnetic tunnel junction can be electrically connected to a control circuit through layer Cap to a metal line formed directly on top of the SOT-MRAM cell 500 by conventional means.

The manufacturing process can be characterized as a self-aligned manufacturing processes of SOT-MRAM cells regarding the positioning of the electrically conductive lines with regards to the SOT layer, which brings an inherent advantage over other types of manufacturing processes of SOT-MRAMs in that it allows a lower variability of the manufactured SOT-MRAM cells because there is no more variability induced by misalignement issues.

A SOT-MRAM cell according to the invention can be easily scaled down and can be obtained by means of a self-aligned process, meaning here that the electrically conductive lines does not require a precise alignment to be adequately positioned with regard to the SOT layer.

Still, while being formed from a self-aligned manufacturing process, a SOT-MRAM according to the invention does not significantly suffer from metal redeposition, as only a small portion of metal is exposed to the isotropic etching of step S4, the only metal exposed at that time being that of electrically conductive lines El_{A} and El_{B} that are mostly covered with the second dielectric layer Diel2.

## Claims

1. A SOT-MRAM (400, 500) comprising :
- a substrate dielectric layer (SubOx);
- a first and a second electrically conductive lines (El_{A}, El_{B}) formed in a same plane over the substrate dielectric layer (SubOx);
- a first dielectric layer (Diel1) over the substrate dielectric layer (SubOx) and interposed between the first and the second electrically conductive lines (El_{A}, El_{B}) ;
- a magnetic tunnel junction (MTJ) formed over the first dielectric layer (Diel1) and comprising a SOT layer (SOT) at a lowermost position of the magnetic tunnel junction (MTJ), the SOT layer (SOT) connecting the first electrically conductive layer (El_{A}) to the second electrically conductive layer (El_{B}), the magnetic memory cell being **characterized in that** top surfaces of the first and the second electrically conductive lines (El_{A}, El_{B}) present depressions at least partially filled with a second dielectric layer (Diel2).

2. The magnetic memory cell (400, 500) according to claim 1, wherein a sidewall of the SOT layer (SOT) is horizontally aligned with a sidewall of other layers (Ferro_{f}, Ins, Ferroₚ) forming the magnetic tunnel junction (MTJ).

3. The magnetic memory cell (400, 500) according to claim 1 or claim 2, the first and the second electrically conductive lines (El_{A}, El_{B}) being formed in respective openings (Open_{A}, Open_{B}) of the first dielectric layer (Diel1).

4. The magnetic memory cell (400, 500) according to any one of claim 1 to claim 3, further comprising a ferromagnetic layer (M2) over the first and the second electrically conductive lines (El_{A}, El_{B}) and surrounding the magnetic tunnel junction (MTJ).

5. The magnetic memory cell (400, 500) according to claim 4, further comprising an electrically insulating encapsulating layer (Encaps) interposed between the ferromagnetic layer (M2) and each of the first and the second electrically conductive lines (El_{A}, El_{B}) and the magnetic tunnel junction (MTJ).

6. The magnetic memory cell (400, 500) according to any one of claim 1 to claim 3, further comprising a dielectric planarization layer (M2) over the first and the second electrically conductive lines (El_{A}, El_{B}) and surrounding the magnetic tunnel junction (MTJ) .

7. The magnetic memory cell (400, 500) according to claim 6, further comprising an electrically insulating encapsulating layer (Encaps) interposed between the dielectric planarization layer (M2) and each of the first and the second electrically conductive lines (El_{A}, El_{B}) and the magnetic tunnel junction (MTJ).

8. The magnetic memory cell (400, 500) according to any one of claim 1 to claim 7, further comprising a first and a second vias (VA, VB) embedded in the substrate dielectric layer (SubOx), the first and the second vias (VA, VB) being respectively in direct contact with the first and the second electrically conductive lines (El_{A}, El_{B})

9. A process for manufacturing a SOT-MRAM, comprising the steps of:
- providing (Start) a substrate (Sub) covered with a substrate dielectric layer (SubOx);
- forming (S1) a first dielectric layer (Diel1) over the substrate, the first dielectric layer comprising a first and a second openings (Open_{A}, Open_{B});
- forming (S2) a first metal layer (M1) and a second dielectric layer (Diel2) over the substrate (Sub) and the first dielectric layer (Diel1);
- grinding down (S3) the first metal layer (M1) and the first dielectric layer (Diel1) by a chemical mechanical polishing process, thereby forming a first and a second electrically conductive lines (El_{A}, El_{B}) having top surfaces presenting depressions at least partially filled with the second dielectric layer (Diel2);
- patterning (S4) a magnetic tunnel junction (MTJ) on the first dielectric layer (Diel1), the magnetic tunnel junction (MTJ) comprising a SOT layer (SOT) as a lowermost part thereof, in direct contact with the first dielectric layer (Diel1) and each of the first and the second electrically conductive lines (El_{A}, El_{B}) .

10. The process according to claim 9, wherein the step of forming (S4) the magnetic tunnel junction (MTJ) comprises :
forming the magnetic tunnel junction (MTJ) by depositing successively and in this order the SOT layer, a free ferromagnetic layer (Ferro_{f}), a tunnel insulating layer Ins and a pinned ferromagnetic layer (Ferroₚ); and
patterning the magnetic tunnel junction (MTJ) by an anisotropic etching of the pinned ferromagnetic layer (Ferroₚ), the tunnel insulating layer (Ins), the free ferromagnetic layer (Ferro_{f}) and the SOT layer (SOT) by using a same mask.

11. The process according to claim 9 or claim 10, further comprising a step (S5) comprising:
- forming successively and in this order an electrically insulating encapsulating layer (Encaps) and a second metal layer (M2) over the patterned magnetic tunnel junction (MTJ) and the first and the second electrically conductive lines (El_{A}, El_{B}) ; and
- polishing the second metal layer (M2) and the electrically insulating encapsulating layer (Encaps) by a chemical mechanical polishing process down to an uppermost surface of the magnetic tunnel junction (MTJ).

12. The process according to claim 10 or claim 11, further comprising a step (S5) comprising:
- forming successively and in this order an electrically insulating encapsulating layer (Encaps) and a dielectric planarization layer (M2) over the patterned magnetic tunnel junction (MTJ) and the first and the second electrically conductive lines (El_{A}, El_{B}); and
- polishing the dielectric planarization layer (M2) and the electrically insulating encapsulating layer (Encaps) by a chemical mechanical polishing process down to an uppermost surface of the magnetic tunnel junction (MTJ).

13. The process according to any one of claims 7 to 9,
wherein a top surface of the provided substrate is covered with a substrate dielectric layer (SubOx) in which a first and a second vias (VA, VB) are embedded, and
wherein the first and the second electrically conductive lines (El_{A}, El_{B}) are formed in direct contact with the first via and the second via (VA, VB), respectively.
